Europäisches Patentamt

European Patent Office

Office européen des brevets

(19)

(11) EP 0 515 288 B1

(12) FASCICULE DE BREVET EUROPEEN

(45) Date de publication et mention
de la délivrance du brevet:
02.07.1997 Bulletin 1997/27

(51) Int Cl.6: C30B 7/00

(21) Numéro de dépôt: 92401416.0

(22) Date de dépôt: 22.05.1992

(54) **Procédé de croissance cristalline hydrothermale à partir de germes obtenus par assemblage de lames**

Verfahren zur hydrothermischen Züchtung von Kristallen aus mittels Impfkristallen zusammengesetzten Blättern

Process for the hydrothermal growth of crystals using seeds obtained by assembling flat sheets

(84) Etats contractants désignés:
AT DE GB

(30) Priorité: 24.05.1991 FR 9106271

(43) Date de publication de la demande:
25.11.1992 Bulletin 1992/48

(73) Titulaires:
• FRANCE TELECOM
75015 Paris (FR)
• CENTRE NATIONAL DE
LA RECHERCHE SCIENTIFIQUE (CNRS)
75794 Paris Cédex 16 (FR)

(72) Inventeurs:
• Detaint, Jacques
F-93250 Villemonble (FR)
• Schwartzel, Jacquie
F-91120 Palaiseau (FR)
• Toudig, Yves
Ploubeze, F-22300 Lannion (FR)
• Philippot, Etienne
F-34270 Saint Mathieu de Trevier (FR)
• Capelle, Bernard
F-94800 Villejuif (FR)
• Zarka, Albert
F-75019 Paris (FR)
• Goiffon, Aline
F-34980 CLément la Rivière (FR)
• Arnaud, Roger
F-74960 Crangevrier (FR)

(74) Mandataire: Warcoin, Jacques et al
Cabinet Régimbeau,
26, avenue Kléber
75116 Paris (FR)

(56) Documents cités:
EP-A- 0 123 809          GB-A- 827 501
GB-A- 2 079 175          US-A- 2 931 712

• J.CRYSTAL GROWTH vol. 71, no. 1, 1 Février
1985, AMSTERDAM,NL pages 269 - 272;
BORDUI ET AL: 'aqueous solution growth of kdp
from spliced seeds'

## Description

La présente invention concerne un procédé permettant l'augmentation des dimensions des cristaux de quartz et des matériaux isomorphes du quartz élaborables par croissance hydrothermale sur germe, dans lequel on utilise un germe obtenu par l'assemblage de plusieurs lames cristallines. Plus précisément, ce procédé permet l'augmentation des dimensions notamment dans des directions cristallines présentant des vitesses de croissances très réduites.

Le quartz et les phosphates ou arséniates métalliques isomorphes du quartz, possèdent en commun la propriété d'être des matériaux piézoélectriques dotés de propriétés très intéressantes qui résultent pour beaucoup d'entre elles de structures très voisines. La structure de la phase alpha de ces matériaux dérive en effet, en première approximation de celle du quartz alpha, par la substitution d'un atome sur deux de silicium par un atome d'aluminium ou de gallium et des atomes restant de silicium par du phosphore ou de l'arsenic. Les analogues les plus étudiés à ce jour sont le phosphate d'aluminium A1PO4 (berlinite) et le phosphate de gallium GaPO4.

L'intérêt du quartz en électronique est maintenant bien connu pour l'obtention d'oscillateurs stables, et la réalisation de filtres ; il résulte principalement de la stabilité en fonction de la température et dans le temps des fréquences de résonances et de la très haute surtension des résonateurs à quartz.

L'intérêt des analogues du quartz est de pouvoir conduire à des stabilités de fréquence et à des surtensions similaires à celles obtenues avec le quartz tout en possédant des propriétés piézoélectriques plus intenses qui permettent de réaliser des filtres ayant des largeurs de bandes relatives beaucoup plus importantes ainsi que des oscillateurs pouvant être beaucoup plus décalés en fréquence que ceux utilisant le quartz. (1) (2) (3) (4).

De plus en plus, la fabrication des dispositifs tant à ondes de surface qu'à ondes de volume, utilisant ce matériau, tend à être effectuée par des techniques collectives sur des tranches de diamètre 75 ou 100 mm. L'obtention de telles tranches suppose l'utilisation de très grands germes qu'il est d'autant plus intéressant d'obtenir par assemblage que le coût des très grands cristaux naturels est très élevé et qu'ils doivent être renouvelés assez fréquemment pour maintenir une qualité cristalline élevée.

La berlinite, monocristal de la phase alpha du phosphate d'aluminium (A1PO4), est celui des composés isostructuraux du quartz dont l'état de développement est le plus avancé actuellement. Il présente l'intérêt de permettre l'obtention de filtres deux fois plus larges et d'oscillateurs deux fois plus décalables que ceux utilisant le quartz, tout en ayant également des orientations conduisant à une très grande stabilité thermique des fréquences de résonance.

Pour ce matériau comme pour le quartz, une difficulté importante est d'obtenir des cristaux de grandes tailles permettant de produire les dispositifs utilisant ce matériau dans des conditions économiquement attrayantes.

Le phosphate de gallium a des propriétés piézoélectriques deux fois plus intenses que la berlinite (et quatre fois plus intenses que le quartz). Ce matériau est en cours de développement dans plusieurs laboratoires et des cristaux de taille (centimètre) suffisante pour réaliser des dispositifs ont été obtenus. Là encore, toutefois, le problème se pose maintenant d'obtenir des cristaux de plus grandes tailles.

## I.1 OBTENTION DES CRISTAUX DE QUARTZ ET ANALOGUES ISOMORPHES DU QUARTZ

### I.1.1 Obtention des cristaux de quartz

Plusieurs procédés de croissance hydrothermale du quartz sont connus (5) (6). Ils utilisent des solutions alcalines de carbonate de sodium ou de soude. Dans ces solvants la solubilité du quartz est directe (elle augmente avec la température) de sorte que le corps mère placé dans la partie basse, plus chaude (de l'ordre de 400°C) de l'autoclave, se dissout sous forme de silicate ; la solution saturée est transportée par convection vers la partie froide (température typiquement inférieure d'une cinquantaine de degrés à la précédente) où elle se désature en déposant du quartz sur les germes. Les conditions de température, de pression (remplissage), les concentrations, et éventuellement les additifs utilisés, contrôlent la vitesse de croissance et la qualité du matériau élaboré. Les conditions qui conduisent à un matériau pur (faible teneur en OH et Al) sont celles où les températures et les pressions sont élevées et les vitesses modérées (quelques dixièmes de mm par jour et par face). Ces conditions sont également celles qui conduisent à une faible densité de dislocations (pourvu que le germe en contienne peu).

### I.1.2 Obtention de cristaux de berlinite de haute qualité

Les cristaux naturels connus de ce matériau sont de très petite taille (mm). Les cristaux de taille significative sont obtenus par synthèse hydrothermale, à partir de germes, dans différentes conditions (pression, température) et différents solvants. Plusieurs méthodes de synthèse hydrothermale conventionnelles ou non sont utilisées pour recristalliser une solution saturée et/ou un corps mère (composé de très petits cristaux de berlinite obtenus par synthèse) sur les germes. Elles mettent en oeuvre des techniques compatibles avec la solubilité rétrograde de ce matériau dans tous les solvants connus (montée lente en température d'une solution saturée, méthode du gradient vertical inverse, du gradient horizontal, du gradient composite et méthodes utilisant des transferts mécaniques du solvant saturé). Les premiers travaux ont utilisé comme solvant l'acide phosphorique dans la gamme de température 150-190°C (7) (8) (9) (10), ensuite, il est apparu que l'utilisation, dans la même gamme de température, de l'acide chlorhydrique (11) (12) ou bien de mélanges des acides phosphorique et chlorhydrique (13) (14), conduisait à une certaine amélioration de la qualité des cristaux. Cependant les surtensions des résonateurs réalisés avec les cristaux obtenus dans toutes ces conditions étaient notablement inférieures à ce qui est souhaitable en vue des applications.

Il a été mis en évidence que ces valeurs modestes des surtensions étaient, comme dans le quartz, liées à la présence d'une impureté, l'hydrogène, se manifestant par la présence de radicaux OH détectables par spectroscopie infrarouge (15) (16), par microscopie électronique (précipitation d'eau) (17) (18), par des mesures de constantes diélectriques et bien sur par la mesure des surtensions de résonateurs (19) (20). Des progrès importants et rapides dans la pureté et la qualité cristalline du matériau ont été ensuite obtenus grâce à des modifications notables des conditions de croissance qui ont consisté dans un premier temps à utiliser des températures de croissance bien supérieures (jusqu'à plus de 280°C (8) et (21) ; puis à combiner l'emploi de températures élevées avec celui d'un nouveau solvant : l'acide sulfurique (22) (23) (24). Ces dernières conditions de croissance permettent, à la fois l'obtention de cristaux ayant des surtensions élevées et des vitesses dans les directions usuelles (z et x) suffisamment élevées.

Ces conditions de croissances sont actuellement celles qui permettent, le mieux, l'obtention de cristaux de qualité suffisante pour les applications (surtension-qualité cristalline), dans des conditions autorisant une production industrielle (elles peuvent être mises en oeuvre dans des autoclaves métalliques de grande taille). Avec ces conditions de croissances, la vitesse de croissance dans l'une des directions cristallographiques simples (axe y) est notablement inférieure (d'environ un ordre de grandeur) à celles, assez proches, observées dans les deux directions x et z (24). Egalement, il existe plusieurs directions de croissance lente particulièrement dans les directions déduites par les symétries du cristal de [01.2] et [10.2]. Ceci conduit à l'apparition de faces naturelles perpendiculaires à ces orientations (faces pi' et pi) et à une morphologie des cristaux relativement semblable à celle des cristaux synthétiques de quartz, avec pour A1PO4 élaboré dans ces conditions le remplacement des faces [01.1] (faces dites "z" et [10.1] ("r") par les faces [01.2] (pi) ; alors que les croissances faites à basse température dans d'autres solvants conduisent à avoir surtout les faces déduites de [01.1] et [10.1].

### I.1.3 Obtention des cristaux des autres analogues de quartz

Le phosphate de gallium est soluble dans l'acide phosphorique mais avec quelques différences avec la berlinite (25) (26) de sorte que, moyennant quelques modifications pouvant concerner les concentrations et les températures, les procédés de croissance hydrothermale de A1PO4 en milieu phosphorique sont transposables au cas de GaPO4 (25) (26) (27). Des méthodes particulières de croissance ou utilisant de la berlinite comme germe ont été développées (28) (29).

L'arséniate d'aluminium peut également être élaboré en utilisant les mêmes techniques et l'acide arsénique comme solvant (30).

### I.2 OBTENTION DE CRISTAUX AYANT DES FORMES OPTIMALES POUR LES APPLICATIONS

Pour le quartz comme pour ses analogues, les orientations cristallines courantes les plus intéressantes pour les applications, sont les coupes AT, BT et ST qui sont des orientations dites Y tournées, dérivées de celle (dite coupe Y) du plan défini par l'axe ternaire (dit axe z) et un axe binaire du cristal (axe x) par une rotation simple autour de cet axe binaire. La plus importante est la coupe AT (proche de Y-33° pour la berlinite (31)). Pour obtenir dans des conditions économiques les plus favorables, des lames ayant ces orientations, compte tenu des techniques et des moyens technologiques connus, les morphologies cristallines (elles sont similaires à quelques détails près concernant le remplacement de faces naturelles par d'autres d'orientations légèrement différentes pour toute la famille des analogues du quartz) les plus intéressantes pour les applications du point de vue du coût de l'obtention des lames, sont celles des cristaux obtenus à l'aide :

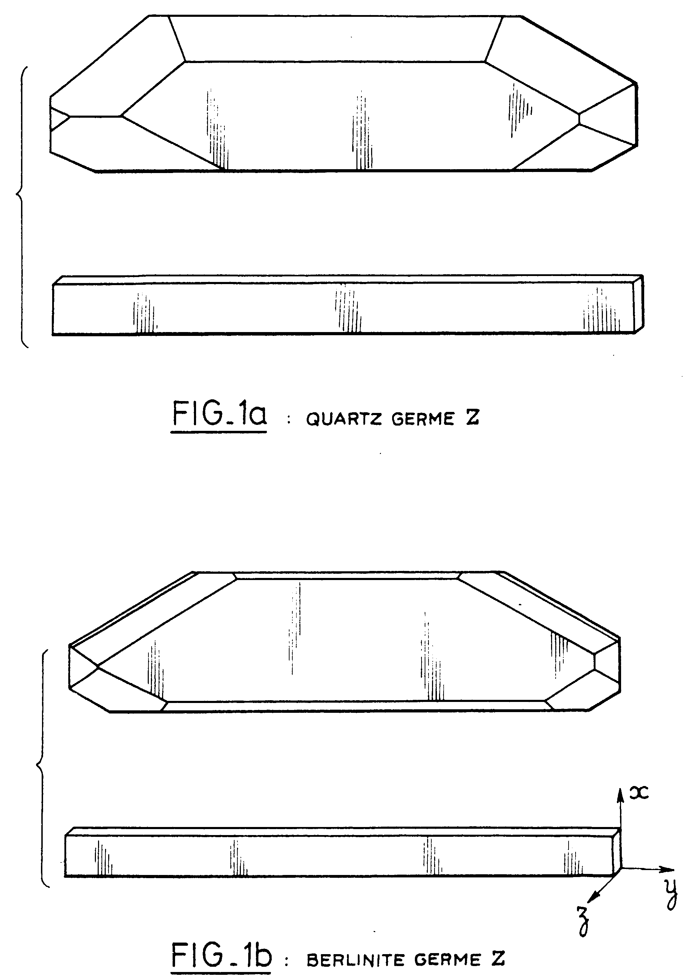

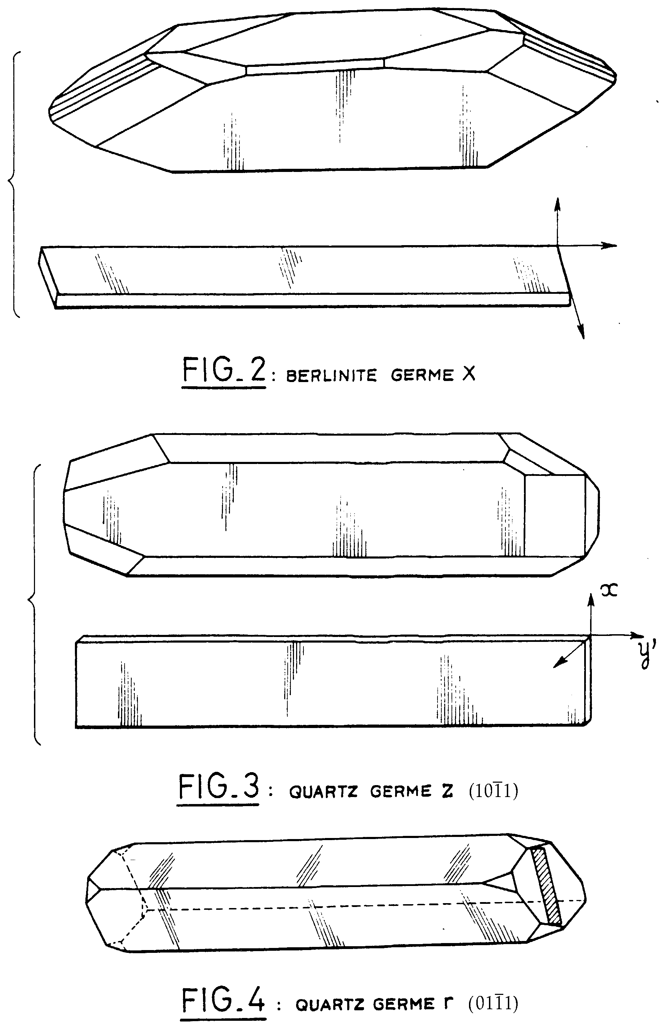

- soit des germes d'orientation normale à l'axe d'origine z (**Figures 1a et 1b**), de grande longueur selon y, et de hauteur, selon l'axe x, nettement inférieure à la longueur. Ceci est le cas le plus courant pour le quartz (**Figure 1a).**
- soit des germes habituellement parallélépipédiques (**Figure 2**) d'orientation normale à l'axe électrique x, présentant une grande longueur selon l'axe Y, une épaisseur faible et une hauteur, selon l'axe optique z, nettement inférieure à la longueur. Ceci est le cas le plus courant pour la berlinite (**Figure 2**).
- soit encore, mais de façon actuellement moins fréquente, de germes ayant l'orientation des faces naturelles 01$\bar{1}$1 (**Figure 4**) ou bien 10$\bar{1}$1 (**Figure 3**), (ou encore 01$\bar{1}$2 ou bien 10$\bar{1}$2), une largeur dirigée selon l'axe x et une grande longueur dans ta direction y' (projection de l'axe y dans le plan de la lame).

Les cristaux élaborés avec des germes 01.1 permettent d'obtenir des lames AT, ST ou BT de très grandes dimensions (tranches pour la réalisation collective de dispositifs piézoélectriques), et conduisent à de très bon rendement matière.

Ces types de cristaux sont également intéressants en raison des faits suivants :

A partir d'un cristal présentant une longueur donnée selon la direction y, il est possible d'obtenir des germes et des cristaux de ces orientations présentant jusqu'à sensiblement une longueur double selon y'.

La perte de longueur (quartz) est moindre lors d'opérations de croissances successives qu'avec les autres orientations de germes usuelles.

Ces morphologies (voir cas typiques sur les Figures 1 à 4) permettent, en effet, d'obtenir les lames individuelles ou les tranches nécessaires à la fabrication des dispositifs avec le rendement matériau le plus intéressant et en minimisant le coût des opérations à effectuer. Ces opérations sont la prétaille, la taille, le débordage (éventuel), le rodage et le polissage.

Pour minimiser les pertes de matériau, et, le coût de l'opération de taille des lames, il est nécessaire que les cristaux et donc les germes aient une longueur importante (un minimum est de l'ordre de 10 cm, le maximum pratique est actuellement de l'ordre de 50 cm) selon y ou y'. La longueur optimale est fonction des équipements utilisés et aussi des autres dimensions finales du cristal.

Les germes sont obtenus par découpe longitudinale de cristaux, le plus souvent des types indiqués ci-dessus. Compte tenu de la forme des extrémités des cristaux, il y a une perte de longueur dans cette opération qui est plus importante, en général, que le gain obtenu lors de la croissance.

Il est donc du plus grand intérêt de disposer d'une technique permettant d'accroître notablement et rapidement la longueur des cristaux selon la direction y. Il est aussi nécessaire que cette technique ne dégrade pas sensiblement la qualité cristalline.

L'état de la technique comporte deux types de techniques pour ce faire.

## II. 1 METHODE D'ALLONGEMENT PAR CROISSANCE

La vitesse de croissance selon la direction y, dans les conditions conduisant à une bonne qualité cristalline (en pratique ce sont celles qui conduisent à une teneur [OH] faible) est trop faible pour permettre d'obtenir un allongement significatif de la longueur des cristaux.

Une meilleure possibilité réside dans l'emploi de conditions de croissance conduisant à une vitesse plus importante selon la direction y, quand on en connaît de satisfaisantes. Ce n'est pas actuellement le cas pour le quartz mais c'est particulièrement le cas pour ses analogues, de la croissance en milieu phosphorique dans la gamme dite des basses températures, allant d'environ 150°C à 190°C. C'est ainsi le cas, pour la berlinite, mais dans une bien moindre mesure, de la croissance dans certains autres solvants possibles de la berlinite, dans cette même gamme de température.

Cette technique a été utilisée par la quasi totalité des auteurs (8) (9) (10) etc, depuis Stanley (7) pour l'étude des phosphates métalliques analogues du quartz. Son intérêt majeur est d'ailleurs de permettre l'obtention à partir de nucléations spontanées des premiers cristaux d'un matériau. Elle a permis d'obtenir des cristaux de berlinite ayant des longueurs selon l'axe y allant jusqu'à environ 4 cm.

Cependant, cette technique présente trois inconvénients majeurs :

- Elle conduit à des cristaux très riches en impureté OH, avec une concentration de l'ordre de 1000 ppm pour la berlinite, qui possèdent de ce fait des paramètres cristallins légèrement différents de ceux des cristaux de haute pureté. Ce fait conduit à avoir à effectuer des croissances intermédiaires avec des conditions conduisant à une réduction progressive des teneurs en impuretés OH pour obtenir des résultats satisfaisants du point de vue de la qualité cristalline.
- Elle demande beaucoup de temps. De très nombreuses opérations de croissances successives seraient nécessaires pour obtenir les longueurs utiles voulues selon y. De ce fait elle est très peu adaptée pour obtenir les nombreux grands germes indispensables pour une production notable.
- Le grand nombre des opérations de croissance successives nécessaires peut conduire à une notable dégradation de la qualité cristalline (probabilité notable d'apparition de dislocations à chaque reprise de croissance, et éventuellement de macles).

## II.2 METHODE D'ALLONGEMENT PAR ASSEMBLAGE DE CRISTAUX

Cette technique est l'objet de recherches depuis pratiquement le début des travaux sur l'élaboration des cristaux de quartz synthétique. En effet, les très grands cristaux naturels permettant l'obtention des grandes longueur de germe nécessaires sont rares et coûteux. Plusieurs méthodes d'assemblage de cristaux ont été proposées pour l'allongement des germes de quartz, une l'a été pour la berlinite. Toutes reposent sur l'assemblage avant croissance de lames d'orientation cristalline aussi identiques que possible par un dispositif évitant toutes les variations relatives d'orientation entre les deux lames pendant la croissance et résistant à la corrosion dans le milieu utilisé par la croissance.

a) Dans les années 1950, la société Clevite a proposé deux procédés pour l'allongement des germes du type "barre Y" [lame allongée selon l'axe y un peu plus mince dans la direction z que dans la direction x] (32) (33). Dans ces procédés, la similitude d'orientation des lames à assembler est essentiellement obtenue par le sciage de ces lames dans un même bloc, par une scie multilame, ce qui selon les auteurs devait assurer une précision suffisante sur les orientations. Les faces d'extrémités des barres à assembler sont obtenues dans une opération unique de sciage devant, selon ces auteurs, assurer une identité d'orientation cristalline.

Dans l'un des procédés (32), les germes sont assemblés par serrage mécanique dans un porte germes en acier prenant appui sur deux des faces latérales de ceux-ci, une couche d'un matériau déformable (argent métallique) est interposé entre les germes et le dispositif de serrage. Dans l'autre procédé (33), les barres Y sont assemblées à l'aide de plaques de quartz cristallin tenues par des fils métalliques dont la croissance ou la dissolution est censée jouer un rôle dans la tenue de l'assemblage. Ces faces, de jonction des deux lames à assembler peuvent avoir une orientation différente de la surface perpendiculaire à l'axe y. Ces auteurs indiquent à juste titre que leur orientation déduite de celle normale à l'axe y dirigé selon la longueur du barreau, par une rotation (de 30 à 60 degrés selon le sens) autour de l'axe optique telle que l'orientation de cette face d'extrémité devienne normale à un des deux axes cirstallographiques d'ordre 2 (autres que celui perpendiculaire à la longueur du barreau).

b) plus récemment I.R.A. Christie et al. (34) ont proposé un procédé permettant l'obtention de germes de quartz de grande longueur (environ 30 cm) par assemblage de deux ou plusieurs lames. Dans ce procédé, deux lames cristallines préalablement revêtues de couches minces métalliques de chrome et d'or, sont assemblées avec recouvrement partiel sur une certaine longueur, en utilisant un procédé de soudure par diffusion entre les couches minces métalliques, sous vide et à haute température. Le germe ainsi obtenu par assemblage est mis en croissance en autoclave selon un procédé connu de croissance hydrothermale du quartz.

Aucune précision n'est donnée sur la méthode permettant d'obtenir les lames à assembler ni sur l'identité d'orientation nécessaire ni sur la précision relative d'orientation nécessaire. Aucune indication n'est donnée sur une méthode permettant d'obtenir lors de l'assemblage un alignement extrêmement précis des axes cristallins des deux lames. En effet, même si les deux lames avaient initialement une orientation similaire, le procédé d'assemblage entraîne une désorientation relative des deux lames par une rotation autour d'un axe perpendiculaire à la surface d'assemblage.

c/ plus récemment encore, EPO 123 809 et B.H.T. CHAI et al. (35) ont proposé un procédé permettant l'augmentation rapide de taille des cristaux des orthophosphates métalliques isomorphes du quartz (A1PO4, GaPO4) par assemblage de lames pour constituer un germe unique. Dans la première variante du procédé, les lames de berlinite ou de GaPO4 sont obtenues, de préférence à partir du même monocristal, par découpe en lames perpendiculaires à l'axe optique, ces lames sont disposées l'une contre l'autre sur un support, en utilisant comme faces latérales d'appui les faces naturelles r et z (ces faces sont celles qui apparaissent lors de la croissance à basse température dans les solvants utilisés par ces auteurs). Pour les maintenir alignées pendant la croissance, ces auteurs utilisent un pressage par des pièces en polymère fluoré agissant sur la face des lames opposée à celle en contact avec le support. Dans une variante, ces auteurs indiquent la possibilité d'utiliser comme face d'appui des faces taillées perpendiculairement à l'axe Y.

Les lames ainsi assemblées sont disposées dans un autoclave horizontal en verre de silice dans lequel la circulation de la solution enrichie en berlinite est accélérée par un basculement périodique. Les conditions de croissance indiquées par ces auteurs pour l'obtention d'un monocristal unique à partir de germes assemblés sont celles alors en leur connaissance (mélange de H3PO4 et de HCl dans des conditions de températures basses et avec des remplissages faibles conduisant à des pressions peu élevées).

Les limitations et les inconvénients de la méthode d'allongement des cristaux, procédant par croissance successives ont été indiqués ci-dessus (II.1). En pratique cette méthode, dont la mise en oeuvre est indispensable dans les première phases du développement d'un matériau pour lequel il n'existe pas de germes naturels, ne peut admettre l'obtention des grands cristaux nécessaires pour les applications industrielles lorsque la vitesse de croissance pour la direction dans laquelle l'augmentation de taille est désirée est faible relativement à celles des autres directions. Ceci est le cas des orthophosphates métalliques isomorphes du quartz, pour lesquels la vitesse de croissance dans la direction y est très faible relativement à celles observées dans les autres directions.

Pour le cas du quartz synthétique, la valeur extrêmement faible de la vitesse de croissance selon y obtenue dans les conditions de croissance actuellement connues, fait que, cette méthode est totalement sans intérêt.

On a découvert selon la présente invention que les méthodes actuellement connues d'allongement des cristaux par assemblage de germes (II$\bar{1}$2) ne sont pas satisfaisantes pour les trois raisons principales suivantes :

- Les procédés proposés et mis en oeuvre pour l'obtention des lames à assembler ne conduisent pas à des orientations suffisamment similaires pour les lames à assembler.

- Les méthodes d'assemblage proposées ne peuvent asssurer initialement et/ou maintenir au cours de la croissance une précision suffisante sur la différence d'orientation relative entre les lames assemblées.

- Dans beaucoup des dispositions proposées, la croissance, des parties utilisables des cristaux ainsi obtenus est perturbée par le montage assurant la tenue des lames assemblées.

En particulier, les deux premiers points ont une extrême importance. On a en effet découvert, selon la présente invention, le fait qu'une désorientation même minime existe entre les lames assemblées conduit à l'apparition de défauts cristallins (dislocations, macles, etc) dont la présence en introduisant des zones de fragilité plus grande et de propriétés acoustiques légèrement différentes, peut rendre les cristaux peu ou pas utilisables. La principale difficulté à cet égard est donc de déterminer la désorientation maximale admissible.

Compte tenu du fait que les méthodes utilisées pour l'assemblage ne font, au mieux que conserver les orientations, et donc qu'augmenter la désorientation relative existant entre les lames, il est nécessaire que celles-ci aient au départ des orientations aussi identiques que possible techniquement. Nos expériences ont montré que les précisions d'orientations des lames avant assemblage doivent être supérieures d'au moins un ordre de grandeur aux valeurs généralement admises et qui sont celles auxquelles conduisent les méthodes proposées dans l'art antérieur (de une demi à quelques minutes d'arc). En effet l'examen de croissance réalisée avec des germes présentant des désorientations relatives de l'ordre de la minute montre que cette désorientation induit un grand nombre de défauts cristallins (dislocations, macles...).

De ce point de vue les procédés utilisant directement les méthodes de sciage pour l'obtention des lames à assembler, y compris celles permettant l'obtention simultanée de plusieurs lames cristallines, conduisent à des dispersions angulaires qui ne sont pas admissibles dans cette application (de l'ordre de une à souvent, plusieurs minutes d'arc). De même, le procédé d'assemblage ne doit pas introduire d'erreurs supplémentaires dans l'identité d'orientation des lames, y compris dans les conditions prévalant lors de la croissance.

Au total, du point de vue de la précision d'orientation initiale des lames ainsi que de celui des imprécisions rajoutées lors de l'assemblage, l'art antérieur est peu satisfaisant. Ceci explique probablement pourquoi les procédés anciens ne sont plus utilisés actuellement malgré l'intérêt économique évident de disposer de telles méthodes.

Dans le procédé décrit en II.2 a), l'emploi d'une fixation mécanique par des pièces d'acier et d'argent assurant un guidage latéral sur une petite partie de la longueur des lames ne peut assurer le maintien d'une très haute précision de positionnement dans les conditions de température existant lors de la croissance en raison du très grand différentiel de dilatation existant entre le quartz et les métaux employés. Pour la variante utilisant des pièces de quartz, la dilatation du fil d'argent utilisé pour le maintien de celles-ci présente les mêmes inconvénients.

Dans le procédé décrit en II.2 b), aucune disposition permettant l'alignement des axes situés dans la longueur des germes n'est indiquée.

Dans le procédé décrit en II.2 c), la précision angulaire indiquée pour la préparation des lames (+-0.05 à +-0.01 degré) est insuffisante pour obtenir une croissance satisfaisante directe dans des conditions conduisant à une teneur en impureté OH faible. Dans ce cas on n'obtient pas avec un rendement acceptable, la formation d'un monocristal sans cassures. Il est en effet apparu que lorsque la concentration en impureté OH est abaissée, pour obtenir les propriétés nécessaires aux applications (surtension élevée), la possibilité d'obtenir des croissances satisfaisantes sur des germes présentant des zones ayant des désorientations de cet ordre, se réduit puis disparaît. Ces considérations sur la faible possibilité qu'ont les cristaux obtenus dans des "bonnes" conditions de croissance d'accommoder de faibles désorientations angulaires (y compris celles apparaissant naturellement entre différents secteurs de croissance par suite de teneurs différentes en impuretés), expliquent également qu'il soit nécessaire de recourir à des précisions d'orientation supérieures.

Le fait de disposer les lames en appui latéral sur des faces naturelles de croissance ne garantit aucunement d'obtenir un faible écart relatif d'orientation entre les lames (erreur en rotation autour d'un axe perpendiculaire au plan d'assemblage) car les faces naturelles considérées (faces r et z du rhomboèdre) sont rarement strictement planes et elles présentent habituellement entre elles un écart angulaire de l'ordre de une à quelques minutes d'arc. Le système de tenue des lames est seulement adapté à la croissance dans des autoclaves horizontaux fonctionnant à des températures peu élevées (usage d'un polymère fluoré). Les conditions de croissance décrites conduisent à l'obtention de cristaux de berlinite très riches en impuretés OH (de plusieurs centaines de ppm à environ un millier selon la vitesse de croissance), ces cristaux ont des surtensions trop faibles et des coefficients de température d'ordre deux et trois trop grands, pour être utilisés pour la réalisation de dispositifs.

Un autre inconvénient de plusieurs des méthodes proposées jusqu'alors est que la croissance cristalline dans les directions destinées à être utilisées est perturbée par la présence du montage destiné à assurer la fixation des lames pendant la croissance. Ceci est particulièrement le cas des méthodes décrites en II.2 a) dans lesquelles une partie du support et le fil d'argent se situent dans la direction principale et utile de croissance, et de celle décrite en II.2 c) dans laquelle les pièces en polymère fluoré se situent également dans la direction de croissance.

La présente invention a pour objet un procédé permettant l'augmentation des dimensions des cristaux de quartz et des matériaux isomorphes du quartz élaborables par croissance hydrothermale, par la réalisation et l'utilisation d'un germe obtenu par assemblage de plusieurs parties ayant des orientations cristallines aussi identiques que possible.

Plus précisément, la présente invention a pour objet un procédé d'accroissement des dimensions des cristaux de quartz et des matériaux isomorphes du quartz, élaborables par croissance hydrothermale sur germe dans lequel on utilise un germe obtenu par assemblage de plusieurs lames cristallines, caractérisé en ce que l'on fait appel à au moins deux lames de longueurs et/ou de largeurs strictement identiques et d'épaisseurs voisines, taillées dans au moins un cristal, et présentant sur trois faces au moins des orientations cristallines dont les écarts entre les lames restent inférieurs à environ 10" d'arc et en ce que lesdites lames sont rapprochées sur un support par des éléments de guidage assurant leur alignement sur les trois faces précitées en conservant des écarts d'orientation cristalline inférieurs à environ 10" d'arc, une face par lame étant laissée libre en vue de la croissance des germes assemblés conduisant à l'obtention d'un monocristal présentant au moins une dimension supérieure à celle correspondant aux lames cristallines de départ. Le support et les éléments de guidage assurent donc la tenue desdites lames une fois celles-ci rapprochées.

Selon la présente invention lesdites lames sont en outre assemblées selon le procédé de la revendication 1 à l'aide d'un montage comportant :

- un support-plan contre lequel l'une desdites trois faces est appliquée, et
- deux pièces de guidage latéral à surface plane coopérant respectivement avec les deux autres faces desdites trois faces par serrage, ledit support et lesdites pièces de guidage latéral assurant ainsi le maintien en position desdites lames.

Bien entendu la planéité du support-plan et le caractère rectiligne des faces d'appui sur les germes des pièces de guidage latéral doivent être conformes à la précision angulaire visée par la présente invention.

La présente invention permet l'obtention, avec des rendements et des qualités cristallines élevés, des grands cristaux, selon l'objet de la revendication 13, de ces matériaux qui sont nécessaires pour obtenir dans des conditions économiques favorables les dispositifs piézoélectriques utilisés dans les matériels électroniques.

La présente invention fournit un procédé répondant mieux que ceux antérieurement connus aux exigences de la pratique, notamment en ce qu'il écarte dans la plus large mesure possible, les inconvénients liés à l'insuffisance de similitude d'orientation cristalline des lames à assembler, ceux liés à la perte de similitude d'orientation due au montage assurant l'assemblage de ces lames ou bien due à l'influence des conditions de croissance cristalline (température, etc..) sur ce montage, ainsi que ceux liés aux perturbations apportées par la présence de parties de ce montage dans des zones de croissance utiles.

Dans un mode de réalisation particulier, lesdites lames cristallines ont des formes inscrites dans un parallépipède de sorte qu'elles comprennent six faces principales deux à deux parallèles et perpendiculaires à chacune des trois directions principales correspondant à la largeur, la longueur et l'épaisseur du parallépipède

- dont quatre faces perpendiculaires deux à deux d'une part à l'épaisseur et d'autre part à la largeur ou à la longueur, de préférence la largeur, ont des écarts d'orientation entre elles, deux à deux dans une même lame d'une part, et d'une lame à l'autre d'autre part, inférieurs à environ 10" d'arc, et
- les deux autres faces perpendiculaires respectivement à la longueur ou à la largeur, de préférence la longueur, ayant des écarts entre elles pour une même lame et d'une lame à l'autre pouvant aller jusqu'à environ 5' d'arc,
- les deux faces perpendiculaires à la longueur ou à la largeur, de préférence la largeur, étant guidée et maintenue par lesdites pièces de guidage et maintien latéral,
- une des faces perpendiculaires à l'épaisseur étant appliquée sur ledit support-plan et l'autre face perpendiculaire à l'épaisseur étant laissée entièrement libre pour la croissance,
- lesdites lames étant assemblées par leurs faces perpendiculaires à la longueur ou à la largeur.

Le procédé objet de l'invention comporte trois étapes qui sont conjointement nécessaires à l'obtention du résultat.

III.1 La première étape concerne l'obtention de deux ou plusieurs lames à assembler. Dans une variante de réalisation, elle consiste à obtenir au moins deux lames de largeurs strictement identiques et d'épaisseurs très voisines taillées dans le même ou dans plusieurs cristaux différents et, telles que les quatre faces correspondantes soient strictement planes et deux à deux parallèles, à mieux qu'une dizaine de secondes d'arc pour quatre faces, les écarts d'orientation cristalline étant, d'une lame à l'autre, pour chacune de ces quatre faces avec celles correspondantes de l'(des) autre(s), inférieurs également à une dizaine de secondes d'arc. Dans le cas du quartz il est même intéressant que ces écarts soient réduits à moins de cinq secondes d'arc.

Pour des raisons pratiques ces lames sont le plus souvent de formes inscrites dans un parallélépipède, et également, elles seront le plus souvent, assemblées selon leur longueur. Contrairement à l'art antérieur, il n'est pas indispensable que les faces perpendiculaires à la longueur présentent entre elles (et d'une lame à l'autre) des écarts d'orientation cristalline aussi réduits que ceux exigés pour les autres faces. Des écarts de l'ordre de quelques minutes d'arc sont admissibles car la précision d'orientations de ces faces n'intervient pas sur l'identité d'orientation après assemblage.

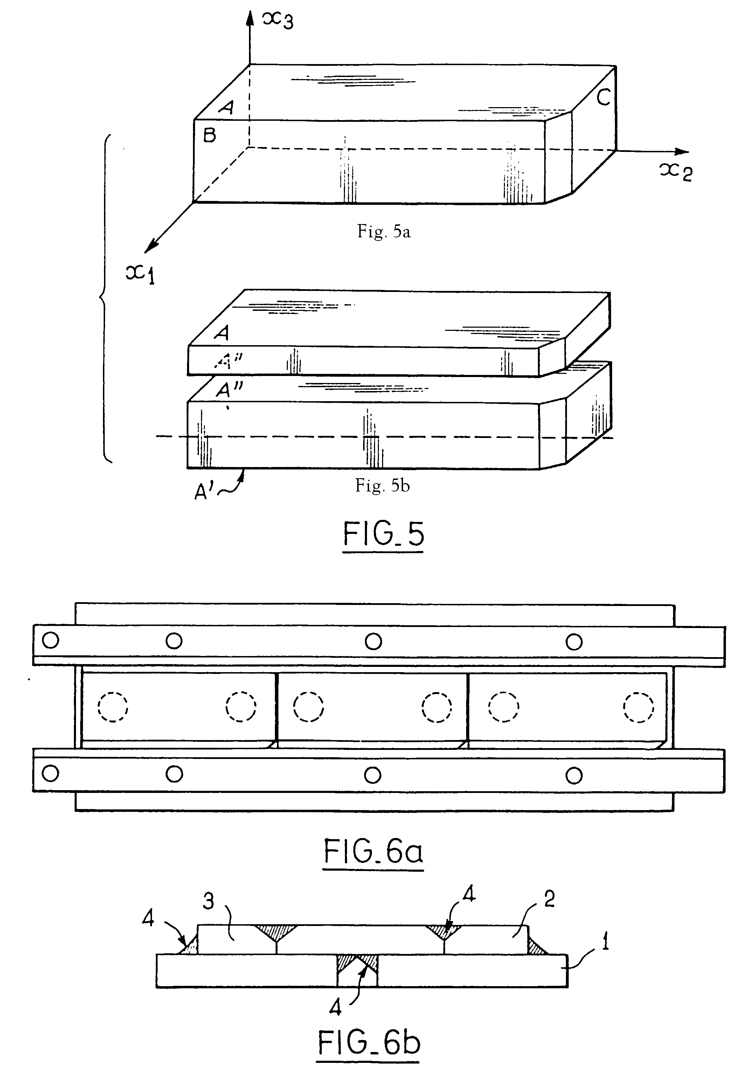

III.1.1 Une méthode satisfaisante et simple pour l'obtention de telles lames est la suivante, telle que représentée sur la Figure 5 :

Un bloc parallélépipèdique est taillé dans un cristal dont trois faces, une selon chacun des trois axes de ce solide (respectivement longueur, largueur, épaisseur), sont orientées à l'aide d'un goniomètre à rayons X selon les trois directions cristallographiques voulues avec une précision de l'ordre de la minute d'arc et mises rigoureusement planes. Par une technique de polissage connue en optique, les trois autres faces correspondantes sont mises parallèles aux trois premières avec la précision voulue (contrôle par interférométrie ou mesure de longueur très précises).

Par sciage dans l'épaisseur, le bloc est divisé en deux lames, les faces sciées (A" et A"' sur la Figure 5) sont remises parallèles aux faces correspondantes d'origines (A et A' sur la figure) avec la précision voulue. Le cas échéant d'autres lames peuvent être ensuite obtenues par division dans l'épaisseur des lames déjà obtenues selon la même méthode.

Un repérage, tel par exemple celui indiqué sur la Figure 5, est fait de façon à conserver l'information sur les sens des axes cristallins normaux aux différentes faces de chacune des lames obtenues.

Cette méthode assure une identité absolue d'orientation cristalline d'une lame à l'autre, pour les faces latérales ce qui est un point très important pour la précision globale.

**III.1.2** Une autre méthode consiste à obtenir directement par les techniques de polissage et de contrôle à l'aide d'un goniomètre à rayons X de haute précision des lames possédant des largeurs identiques et des orientations cristallines précises (dans l'absolu) avec l'écart voulu pour au moins les trois faces indispensables au procédé d'assemblage. Les autres faces étant orientées avec des procédés de précision moindre (par exemple de l'ordre de la minute d'arc). Cette technique qui est notablement plus délicate et plus longue à mettre en oeuvre que la précédente, peut cependant être utile quand les différentes lames doivent être obtenues à partir de cristaux différents.

**III.2** La deuxième étape concerne l'assemblage des lames en vue de la croissance. Elle consiste à assurer que les faces destinées à croître (une par lame), aient entre elles un écart d'orientation minimal, et à conserver du mieux possible la précision d'orientation relative obtenue lors de la préparation des lames. Pour cela, celles-ci sont guidées sur trois faces par des pièces ayant des surfaces rigoureusement planes constituées de matériaux ayant de préférence des coefficients de dilatation similaires à ceux des matériaux à assembler. En outre, de préférence ces matériaux sont naturellement (ou sont rendus) inaltérables dans le milieu de croissance. La nature et les dimensions des pièces utilisées dans le dispositif de support et maintien des lames sont choisies de façon à obtenir un ensemble aussi indéformable que possible. Un exemple pratique de réalisaton est indiqué sur la Figure 6.

Sur cette figure le support 1 possède une face rigoureusement plane obtenue par rodage, l'écart à la planéité parfaite devant être compatible avec la précision visée. Un écart de l'ordre de un micromètre sur une distance de plusieurs centimètres étant souvent le maximum tolérable. La planéité du support-plan est habituellement de l'ordre de 0,5 à 1 micromètre pour un support mesurant environ 12 x 8 cm. Ce support peut être constitué pour le cas du quartz d'un acier spécial à très faible dilatation du type Invar, Elinvar, Durinval des Aciéries d'Imphy, par exemple de préférence revêtu d'une couche d'argent (cette couche ayant pour rôle d'éviter toute corrosion et/ou la formation d'une couche de passivation sur l'acier ce qui peut être nuisisble pour la précision. Pour le quartz des alliages à faible dilatation constitués de métaux précieux de la famille du platine peuvent également être employés.

Dans le cas des phosphates ou arséniates métalliques, la silice vitreuse pure et surtout le quartz cristallin sont des matériaux très satisfaisants. Les pièces de guidage 2 et 3 doivent avoir des faces d'appui sur les lames à assembler rigoureusement planes. Il est intéressant que le matériau utilisé pour les pièces de guidage 2 et 3 soit le même que pour la pièce 1 et qu'il ait des dilatations similaires à celles des lames à assembler.

Sur la Figure 6 on voit que le principe retenu permet de laisser une des faces des lames assemblées entièrement libre pour la croissance.

De façon à empêcher la dissolution dans la phase initiale de l'opération de croissance, et ensuite, la croissance, sur les faces d'appui des lames sur le dispositif de maintien, ce qui est fréquent dans l'art antérieur et qui détériore beaucoup la précision de l'assemblage, les lames sont de préférence revêtues sur ces faces et également sur les faces selon lesquelles elles sont assemblées entre elles, (dans le même but) de couches minces de métaux précieux notamment argent, or, platine ou autres. De même un revêtement de métaux précieux peut être utile pour empêcher des attaques et/ou dépôts indésirables sur les pièces de fixation (nucléations spontanées, couches de passivation, etc..).

Du fait de la métallisation effectuée, les faces en regard des lames assemblées ne sont pas en contact direct. Dans le cas des analogues du quartz, il est même possible de laisser entre les lames un intervalle de l'ordre de cinq centièmes à un dixième de mm sans grand inconvénient. Il a été observé que la présence, sur ces faces en regard de couches minces de métaux précieux ou même de couches plus épaisses (quelques centièmes de mm) obtenues par cuisson d'une laque était favorable à la qualité de la croissance.

Dans le but d'avoir un assemblage indéformable pour la croissance, l'ensemble des pièces constituant le montage (lames constituant le germe et pièces constituant le dispositif support de guidage et maintien) est maintenu en plusieurs points, de façon à ne pas nuire à la précision de l'assemblage, avec des couches métalliques, adhérentes sur les matériaux utilisés, et obtenues par la cuisson de laques à base d'un métal précieux 4. Des dispositifs complémentaires de fixation des pièces 1, 2 et 3 peuvent être utilisés en particulier dans le cas de germes de grandes dimensions.

Ces laques d'argent, d'or, de platine dont l'emploi est connu pour la fabrication des dispositifs piézoélectriques sont cuites à haute température (typiquement 500 à 550°C soit des températures inférieures à celle de la transition de phase alpha-beta des matériaux à assembler. Cette cuisson a pour effet de laisser une couche métallique pratiquement pure très résistante, et d'épaisseur généralement de l'ordre de quelques dixièmes de mm, qui adhère très fortement aux pièces à assembler. Cette méthode permet de simplifier beaucoup l'assemblage de pièces et d'obtenir un bon comportement aux hautes températures utilisées pour la croissance. Des laques d'or ou de platine sont satisfaisantes dans tous les cas, pour le quartz on cite plus particulièrement les laques d'argent. Les couches métalliques obtenues ont la propriété de très peu perturber la croissance.

De préférence donc, toutes les faces des lames assemblées, sauf celles destinées à croître, sont revêtues de couches minces métalliques empêchant dissolution et croissance, notamment de métaux précieux.

En particulier, les lames sont fixées sur le support et les pièces du montage et éventuellement entre elles par des couches métalliques adhérentes obtenues par cuisson de laque de métaux précieux.

On notera que l'une (ou les) pièce(s) de guidage latéral du dispositif peu(ven)t être remplacée(s), après le positionnement précis des lames et avant la croissance, par un collage latéral avec une couche métallique épaisse obtenue par cuisson à haute température de laque de métaux précieux.

**III.3** La troisième étape concerne la mise en croissance des lames assemblées.

Il est souhaitable de choisir pour cette étape des conditions de croissance hydrothermale conduisant à une bonne qualité cristalline. Comme il a été indiqué ci-dessus, ces conditions sont également celles qui conduisent à des teneurs faibles en OH et donc à des surtensions élevées.

Pour le quartz, on utilisera donc de préférence des conditions conduisant à des surtensions supérieures à 2 millions (5) (6). Pour la berlinite les conditions de croissance en milieu sulfurique décrite dans le brevet FR 2 595 344 sont très satisfaisantes pour cette application. Pour le GaPO4 celles décrites dans les références (26) (27) peuvent être utilisées.

Comme il sera vu dans les exemples selon l'invention, on peut effectuer (1) une croissance du germe obtenu par les lames assemblées puis une découpe de nouvelles lames dans le monocristal obtenu, et (2) une nouvelle croissance d'un germe obtenu par assemblage desdites nouvelles lames, de manière à obtenir une augmentation progressive de la surtension des cristaux obtenus par modification des paramètres de croissance.

Le procédé selon l'invention permet d'obtenir des cristaux originaux de par leur taille et leur pureté ou haut facteur de surtension. On obtient notamment des cristaux de berlinite de grande taille, notamment supérieure à 10 cm, et une haute pureté avec une teneur en impureté OH inférieure à 30 ppm et un facteur de surtension Q supérieur à 750000 à 5 MHz.

Une originalité de ces cristaux tient également en ce qu'ils ont une morphologie isométrique selon les axes de croissance x et z lorsque l'on accroît la taille des cristaux de berlinite selon la direction y.

Pour les cristaux pour lesquels il n'existe pas de germes naturels, tels que la berlinite, une longueur selon l'axe y au-delà de quelques centimètres ne peut être obtenue qu'avec un procédé selon l'invention.

Les Figures 1 à 4 représentent des exemples de morphologie de cristaux de quartz et de berlinite.

La Figure 1a représente la morphologie d'un cristal de quartz à germe Z.

La Figure 1b représente la morphologie d'un cristal de berlinite à germe Z.

La Figure 2 représente la morphologie d'un cristal de berlinite à germe X.

La Figure 3 représente la morphologie d'un cristal de quartz à germe z.

La Figure 4 représente la morphologie d'un cristal de quartz à germe r.

La Figure 5 représente l'obtention de lames ayant des orientations cristallines aussi identiques de possible

5a bloc ayant les 6 faces parallèles deux à deux et perpendiculaires entre elles.
5b Après découpe la face A" est remise parallèle à la face A alors que la face A''' est mise parallèle à la face A'.

La Figure 6 représente l'assemblage de lame Z de berlinite pour constituer un germe unique. (1) = support-plan, (2) et (3) = pièces de guidage latéral, (4) = laque métallique.

La Figure 6a représente une vue de dessus.
La Figure 6b représente une vue en coupe.

La Figure 7 (Exemple 1) représente l'assemblage de lames de berlinite Z. (1) = Support-plan, (2) et (3) = pièces de guidage latéral, (5) et (6) = lames de berlinite Z d'orientation identique, (7) = laque d'argent, (8) = laque d'or.

La Figure 8 représente une variante de l'Exemple 2 : Après alignement dans le montage les lames sont fixées par l'emploi d'une laque métallique 9.

La figure 9 représente une variante de l'Exemple 2 (suite) : Remplacement après l'assemblage de la Figure 8 des pièces de guidage latéral par un dépôt de laque métallique les fixant solidement sur le support-plan (1) et maintenant l'identité d'orientation.

La Figure 10 représente la morphologie des cristaux obtenus à partir du montage de la Figure 7.

La Figure 11 (Exemple 4) représente l'assemblage de lames de quartz Z pour constituer un germe unique.

La Figure 11a représente une vue de dessus.

La Figure 11b représente une vue en coupe.

La Figure 12 (Exemple 6) représente l'assemblage de lames de GaPO4 d'orientation z pour augmenter la longueur selon l'axe x.

L'invention sera mieux comprise à la lecture des quelques exemples donnés ci-dessous à titre non limitatif.

EXEMPLE 1 - Obtention de grands cristaux de berlinite par assemblage de lames d'orientation normale à l'axe optique (Coupe Z)

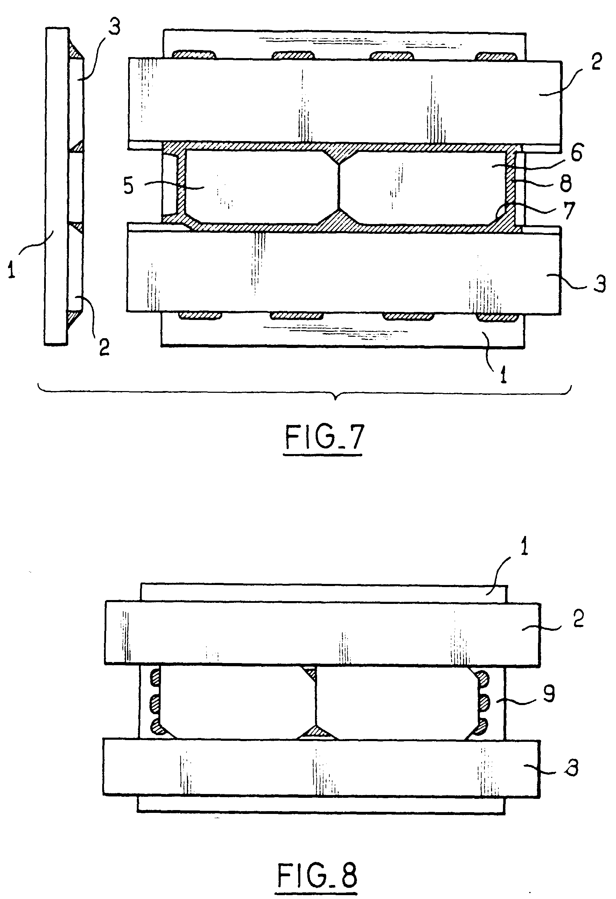

Un bloc de dimension 0.6X3x1cm a été prélevé en dehors du germe, dans le secteur de croissance +X d'un cristal élaboré à partir d'un germe de coupe X par croissance à haute température en milieu sulfurique. Dans ce bloc, en utilisant la technique décrite en III.2 deux lames d'orientation identiques pour les faces normales à l'épaisseur et à la largeur ont été obtenues (Figure 7) avec une précision d'environ 10 secondes d'arc (soit un écart de parallélisme des faces considérées de l'ordre de 1 micron sur la longueur de 3 cm), les faces considérées étant polies avec un écart à la planéité très inférieur à 0.5 micron. Les faces normales à la longueur ont été obtenues par orientation aux rayons X sur le bloc, leur écart angulaire est inférieur à 2 minutes d'arc. Trois des coins des lames (5,6) ont été découpés de façon à constituer un repérage d'orientation (7) et aussi pour assurer ultérieurement leur maintien par collage. Les pièces du montage d'assemblage sont en quartz cristallin de coupe Z ce qui assure une excellente similitude de dilatation : les faces utiles ont été rendues planes par rodage, les pièces 2 et 3 ayant la même épaisseur que les lames de berlinite (5,6).

Les deux lames de berlinite (5,6) ont été métallisées sous vide sur les 5 faces non utilisées pour la croissance avec une sous couche de zirconium et une couche d'or d'environ 0,4 micron (8).

L'assemblage des lames a été effectué en deux étapes :

- Dans la première, les lames de berlinite ont été mises en place de façon à ce que leurs axes cristallographiques x et y soient disposés dans le même sens (signe compris) ; à l'aide d'un dispositif auxiliaire les pièces 2 et 3 ont été serrées contre les lames assurant ainsi leur alignement rigoureux dans leur plan. Après qu'une laque d'argent (9) (composition de polyimide et d'argent) ait été disposée en quelques points (Figure 8) de façon à maintenir rigidement l'ensemble après cuisson, les germes et les pièces 2 et 3 ont été appliqués à l'aide d'une presse spécialement réalisée sur le support 1 de façon à éviter toute erreur d'orientation par rapport à ce plan. L'ensemble du montage a ensuite été porté à 200° de façon à cuire la laque d'argent utilisée. Celle-ci est uniquement destinée à maintenir l'ensemble pendant l'étape suivante.

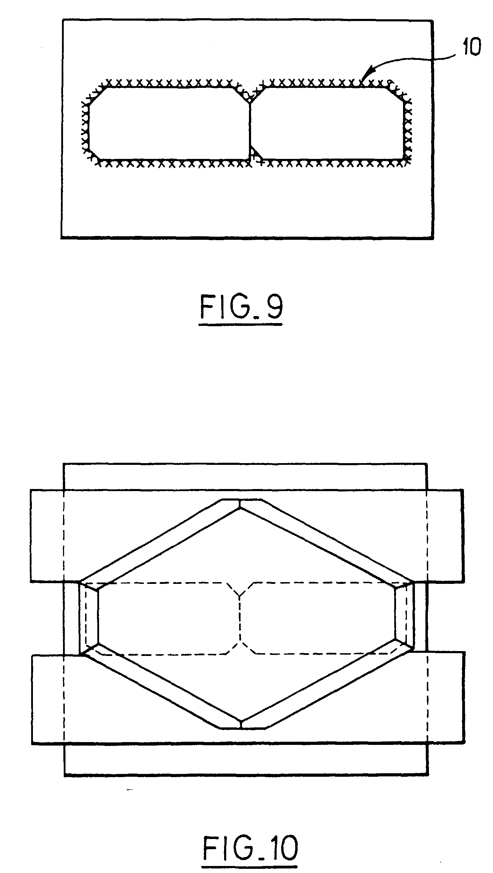

- Dans la deuxième étape, une laque d'or (10) cuisant à 520° est disposée comme indiquée sur le Figure 9 de façon à obtenir un assemblage très résistant après cuisson.

Cet assemblage a été disposé dans un autoclave vertical utilisé pour la croissance de la berlinite en milieu sulfurique selon le procédé décrit dans la référence (22). Après 8 jours de croissance à 210° un cristal unique ayant la forme indiquée sur la Figure 10 a été obtenu. Par sciage le long des pièces de quartz, le germe obtenu par assemblage peut être séparé de la croissance (et réutilisé). Dans la croissance obtenue, des lames X ont été taillées.

Ces lames ont ensuite été mises en croissance en milieu sulfurique 4,5 M à 240°C et ont permis d'obtenir des cristaux de longueurs supérieurs d'environ 60% à celui de départ et qui présentent une très haute surtension permettant la réalisation de résonateurs.

Le procédé peut être réitéré jusqu'à obtention de la longueur désirée.

EXEMPLE 2 : Allongement de cristaux de berlinite par assemblage de lames d'orientation normale à l'axe Z

Deux lames de berlinite de coupe Z de dimensions voisines de 25x10x1,5 mm ont été obtenues, de même que dans l'exemple 1, avec des orientations extrêmement similaires selon la méthode décrite au début du paragraphe III.1 et dans l'exemple précédant. De même, elles ont été revêtues sur 5 faces de couches minces de zirconium et d'or.

L'assemblage a été effectué en deux étapes : la première est similaire à celle de l'exemple 1 (Figure 8) : dans la deuxième, les pièces de guidage latéral ont été remplacées, l'une après l'autre, par un dépôt de laque d'or cuisant à 520°C sur les faces de lames et la pièce support 1 (Figure 9).

Le germe obtenu par assemblage a été mis en croissance dans un autoclave fonctionnant selon le principe du gradient horizontal utilisant comme solvant de l'acide phosphorique 6M et une température de cristallisation de 180°C. Un cristal unique présentant un développement selon l'axe z plus important que dans l'exemple 1 et un développement latéral selon l'axe x moindre a été obtenu. Ce cristal a été découpé en lames d'orientation X qui ont été utilisées comme germes pour faire croître des cristaux en milieu sulfurique 6M à 210°. De même que dans l'exemple 1 des lames taillées dans ces derniers cristaux ont été utilisées pour obtenir des cristaux à haute surtension destinés à l'élaboration de résonateurs.

EXEMPLE 3 : Allongement de cristaux de berlinite par assemblage de lames d'orientation normale à l'axe x

Trois lames d'orientation très précisément similaires, et de dimensions 35X10X2mm ont été obtenues comme indiqué au paragraphe III.1.1. dans un bloc parallélépipédique de berlinite provenant de la zone +X d'un cristal de berlinite à haute surtension. Leur épaisseur est dirigée selonl'axe x.

Elles ont été métallisées sur les cinq faces non utilisées pour la croissance avec des couches minces de platine (1000 Å) puis d'or (4000 Å). L'assemblage a été effectué comme indiqué sur la Figure 11. Une laque d'or a été disposée sur toute la périphérie des lames à assembler et des pièces de guidage comme indiqué sur la Figure 11. Cette laque a été cuite à 520°C alors que les lames cristallines et les pièces de guidage latéral étaient pressées sur le support 1. Une opération de rodage a ensuite permis d'obtenir que les pièces de guidage et les lames assemblées soient exactement de la même épaisseur.

L'assemblage a été disposé dans un autoclave vertical pour croissance selon la méthode du gradient vertical inverse en milieu sulfurique 4M à 250°C. Le cristal unique obtenu par croissance a été séparé du germe obtenu par assemblage par sciage puis découpé en lames pouvant directement servir de germes pour l'obtention de cristaux destinés à la réalisation de résonateurs.

EXEMPLE 4 : Allongement de cristaux de quartz selon la direction y

Dans un cristal de surtension très élevée et de haute qualité cristalline, de 22cm de long obtenu par croissance sur un germe Z de 22mm de hauteur et présentant une croissance légèrement supérieure à 25mm sur chaque face du germe, un bloc de 155x20X20mm a été découpé en zone Z. Les 4 grandes faces de ce bloc ont été rendues parallèles et polies avec une erreur maximale de l'ordre d'un demi micron. Dans ce bloc deux lames d'épaisseurs normales à l'axe x, de largeur suivant l'axe z et de longueur selon y, de dimensions finales voisines de 7x150x18mm et présentant entre elles une différence d'orientation (sur les quatre grandes faces) dans tous les sens, inférieure à 3 secondes d'arc ont été obtenues selon la technique décrite au paragraphe III.1.1. Ces lames ont été attaquées pendant 5 minutes dans une solution de bifluorure d'ammonium saturée à 70° C de façon à éliminer les défauts de surface dus au polissage.

Toutes les faces de ces lames, sauf la face +x, ont été métallisées par dépôt sous vide d'une fine couche de nichrome et d'une couche d'argent de 1,5 microns.

Un montage utilisant 3 pièces de guidage en Invar, totalement revêtues d'une couche métallique d'argent d'environ 4 microns, obtenue par un dépôt sous vide suivi d'un épaississement électrolytique a été utilisé pour l'assemblage des lames. Les faces utiles de ces pièces avaient été, au préalable, rectifiées et rodées de façon à avoir la précision de planéité voulue.

Dans le montage (Figure 11), les lames cristallines ont été disposées de telle façon que la face destinée à recevoir la croissance soit la face +x et que les axes y soient alignés et de même sens. De la laque d'argent a été déposée en plusieurs fois (avec une cuisson après chaque dépôt) dans les chanfreins prévus sur les pièces d'assemblage et les lames.

La croissance dans des conditions conduisant à une surtension supérieure à 2,2 millions a conduit à un cristal unique de 30 cm de longueur qui a permis d'obtenir des germes puis des cristaux, d'une longueur très supérieure à celle des cristaux de départ.

EXEMPLE 5 : Augmentation de la hauteur sur l'axe x de cristaux à germes 10.1 (face z) pour obtention de tranche de quartz de 4 pouces sans germes

A partir d'un bloc de 250x55x15 mm taillé d'un côté du germe d'un cristal à germe [10$\overline{1}$ 1] (face z), deux lames parallélipipédiques de 245x50x5 mm d'orientation similaire sur les 4 faces (x et z) à mieux que 5 secondes d'arc ont été préparées, attaquées et métallisées ainsi que décrit en III.4. Les lames ont été assemblées selon la direction de l'axe x dans un montage de principe similaire et utilisant le même matériau que celui décrit en III.4. de façon à obtenir un germe unique de 100 mm de hauteur selon l'axe X. Par croissance de ce germe, et à la deuxième génération, il a été possible d'obtenir des cristaux permettant chacun l'obtention de 40 tranches rondes de quartz AT ou ST de 4 pouces de diamètre.

EXEMPLE 6 : Augmentation de la longueur selon l'axe x de cristaux de GaPO4 à germes 10.1 (face z)

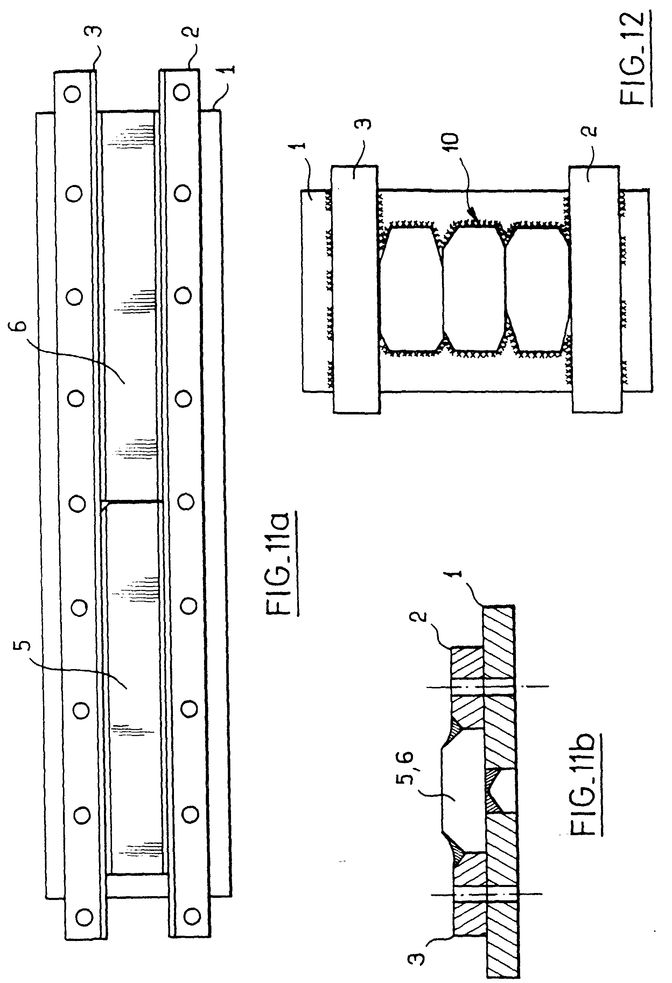

Dans un cristal de GaPO4 d'environ 1 cm$^3$ de volume, ayant la morphologie indiquée sur la Figure 12, un bloc dont l'épaisseur est dirigée perpendiculairement au plan [10$\overline{1}$ 1], la largeur selon un axe x, et la longueur selon l'axe y' défini au paragraphe 2 a été taillé en orientant à l'aide d'un goniomètre à rayons X une de chacune des faces X et z, les faces en regard étant obtenues en les mettant rigoureusement parallèles aux premières. On a laissé tel que brut de croissance les faces naturelles existantes aux extrémités du bloc.

Par la méthode indiquée au paragraphe III.2 trois lames de 1,2 mm d'épaisseur et d'orientation très similaire ont été obtenues, attaquées et métallisées sur la face destinée à être en appui sur le support (Figure 12).

Ce dernier, ainsi que les pièces de tenue latérale ont été réalisées en quartz de coupe AT. L'assemblage a été réalisé comme indiqué sur la Figure 12 en utilisant une laque polyimide chargée à l'or qui a été disposée sur le pourtour des lames.

Par croissance selon la méthode de montée lente entre 190° et 250°C en milieu phosphorique, un cristal unique de 3mm d'épaisseur de 20mm selon x et de 15mm selon y', a été obtenu qui a permis d'obtenir deux germes d'orientation 10.1. Par croissance selon la méthode du gradient vertical sur ces germes de cristaux présentant des dimensions de l'ordre de 25x15x25mm pouvant servir à obtenir par un nouvel assemblage dans la direction y', un germe d'une longueur d'environ 50mm.

L'invention a également pour objet les cristaux obtenus par ce procédé.

## REFERENCE

(1) Z.P. Chang, G.R. Barsch IEEE trans.Sonic Ultrason.vol23 n°2 p 127 (1976)

(2) J. Détaint, M. Feldmann, J. Hénaff, H. Poignant, Y. Toudic proc. 33rd Annual Symposium on Frequency Control p.70 (1979)

(3) J. Détaint, A. Zarka, B. Capelle, Y. Toudic, J. Schwartzel, E. philippot, J.C. Jumas, A. Goiffon, J. C. Doukhan, Proc. 41st Annual Frequency Control Symposium p (1986).

(4) J. Détaint, J. Schwartzel, R. Lefevre, J.P. Aubry, L. Michel, B. Capelle, A. Zarka, E. Philippot, Proc. 2nd European Time and Frequency Forum p 378 (1988)

(5) A. Regreny Thèse Université de Paris VI 20 juin 1973 et rapports internes CNET.

(6) R.A. Laudise, R.L. Barns. IEEE trans. on Ultrasonics Feroelectrics frequency Control vol.35 n°1 p 277 (1988)

(7) J.M. Stanley Industr. Eng. Chem. vol 46 n°8 p 1684 (1954)

(8) H. Poignant, L. le Maréchal, Y. Toudic. Material Research Bull vol 14 n°5 (1979)

(9) E.D. Kolb. R.A. Laudise J. Cryst. Growth (1979)

(10) E.J. Ozimek, B.H.T. Chai Proc. 33rd Annual Frequency Control Symposium p80 (1979)

(11) J. Détaint, H. Poignant, Y. Toudic Proc. 34th Annual Frequency Control Symposium p 93 (1980).

(12) E.D. Kolb. R.A. Laudise, J.C. Grenier J. Cryst. Growth vol 50 p 504 (1980).

(13) O. Retout Thèse Université de Montpellier 23 novembre 1984

(14) B.H.T. Chai E. Buehler, J.J. flynn Brevet US 4481069 6 nov 1984

(15) R.F. Steinberg, M.K. Roy, A.K. Estes, B.H.T. Chai, R.C. Morris Proc. Ultrasonics symposium 1984.

(16) J.C. Jumas. A. Goiffon, B. Capelle, A. Zarka, J.C. Doukhan, J. Schwartzel, J. Détaint, E. Philippot, J. Cryst. Growth vol 80 p 133, (1987).

(17) J. Doukhan, B. Boulogne, Ph. Cordier, E. Philippot, Y. Toudic J. Cryst. Growth vol 84 p 167 (1987).

(18) Ph. Cordier, B. Boulogne, J.C. Doukhan Bull. Mineral. vol 111 p 113( 1988).

(19) J. Détaint. E. Philippot, J.C. JUMAS, J. Schwartzel, A. Zarka, B. Capelle, J.C. Doukhan Proc. 40th Annual Frequency Control Symposium p 234 (1985).

(20) J. Détaint, E. Philippot, B. Capelle, Y. Toudic, J. Schwartzel, J.C. Jumas, A. Goiffon, J.C.

Doukhan, Proc. 2nd Frequency Control and Synthesis Symposium p314 (1987).

(21) J.C. Jumas, A. Goiffon, Y. Toudic, J. Schwartzel, J. Détaint, E. Philippot Mat. Res. bull. vol 22 p 1063 (1987).

(22) E. Philippot, J.C. Jumas, A. Goiffon, M. Maurin, J.C. Doukhan, A. Zarka, B. Capelle, Y. Toudic, J. Détaint, J. Schwartzel Brevet Français 8603009.

(23) E. Philippot, A. Goiffon, J.C. Jumas, C. Avinens, J. Détaint, J. Schwartzel, A. Zarka. Proc 42nd Annual Frequency Control Symposium p138 (1988).

(24) E. Philippot, A. Goiffon, M. Maurin, J. Détaint, J. Schwartzel, Y. Toudic, B. Capelle, A. Zarka J. Cryst. growth à paraître 1990

(25) H. Poignant Thèse Université de Rennes 25 octobre 1979

(26) A. Goiffon. G. Bayle, R. Astier, J.C. Jumas, M. Maurin, E. Philippot. Rev. Chimie Minérale vol 20 p338 1983.

(27) S. Hirano, K. Miwa, S. Naka J. Cryst Growth vol. 79 p215 (1986).

(28) E. Philippot et al Brevet français 840192 8 fév. 1984.

(29) E. Philippot et al. Brevet français 8401911.

(30) A. Goiffon, JC. Jumas, R. Astier, E. Philippot. J. Cryst. Growth vol. 71 p763 (1985).

(31) E. Philippot, A. Ibanez, A. Goiffon, X. Buisson, R. Arnaud, B. Capelle, A. Zarka, Y. Toudic, J. Schwartzel, J. Détaint Proc. 4th European Frequency and Time Forum à paraître 1990.

(32) W.H. Charbonnet Brevet U.S. 2914389 24 nov. 1959.

(33) T.J. Turobinski Brevet US 2931712 5 avril 1960.

(34) I.R.A. Christie, D.F. Croxall, B.J. Isherwood Brevet US 4381214 26 avril 1983 (brevet anglais 8021023 26 juin 1980).

(35) B.H.T. Chai; E. Buehler, J.J. Flynn, R.C. Morris Brevet US 4578146 25 mars 1986.

## Revendications

1. Procédé d'accroissement des dimensions des cristaux de quartz et des matériaux isomorphes du quartz, élaborables par croissance hydrothermale sur germe, dans lequel on utilise un germe obtenu par assemblage de plusieurs lames cristallines, caractérisé en ce que l'on assemble au moins deux lames de longueurs et/ou de largeurs strictement identiques et d'épaisseurs voisines, taillées dans au moins un cristal, et présentant sur trois faces au moins des orientations cristallines dont les écarts entres les lames restent inférieurs à environ 10" d'arc et en ce que lesdites lames sont rapprochées sur un support par des éléments de guidage, assurant ainsi leur alignement sur les trois faces précitées en conservant des écarts d'orientation cristalline inférieurs à environ 10" d'arc, une face par lame étant laissée libre en vue de la croissance des germes assemblés conduisant à l'obtention d'un monocristal présentant au moins une dimension supérieure à celle correspondant aux lames cristallines de départ, et lesdites lames étant assemblées à l'aide d'un montage comportant :

- un support-plan contre lequel l'une desdites trois faces est appliquée, et
- deux pièces de guidage latéral à surface plane coopérant respectivement avec les deux autres faces desdites trois faces par serrage, ledit support et lesdites pièces de guidage latéral assurant ainsi le maintien en position desdites lames.

2. Procédé selon la revendication 1, caractérisé en ce que lesdites lames cristallines ont des formes inscrites dans un parallépipède de sorte qu'elles comprennent six faces principales deux à deux parallèles et perpendiculaires à chacune des trois directions principales correspondant à la largeur, la longueur et l'épaisseur du parallépipède

- dont quatre faces perpendiculaires deux à deux d'une part à l'épaisseur et d'autre part à la largeur ou à la longueur, ont des écarts d'orientation entre elles, deux à deux dans une même lame d'une part, et d'une lame à l'autre d'autre part, inférieurs à environ 10" d'arc, et
- les deux autres faces perpendiculaires respectivement à la longueur ou à la largeur, ayant des écarts entre elles pour une même lame et d'une lame à l'autre pouvant aller jusqu'à environ 5' d'arc,
- les deux faces perpendiculaires à la longueur ou à la largeur étant guidée et maintenue par lesdites pièces de guidage et maintien latéral,
- une des faces perpendiculaires à l'épaisseur étant appliquée sur ledit support-plan et l'autre face perpendiculaire à l'épaisseur étant laissée entièrement libre pour la croissance,
- lesdites lames étant assemblées par leurs faces perpendiculaires à la longueur ou à la largeur.

3. Procédé selon l'une des revendications 1 ou 2, caractérisé en ce que toutes les faces des lames assemblées, sauf celles destinées à croître, sont revêtues de couches minces métalliques, notamment de métaux précieux, empêchant dissolution et croissance.

4. Procédé selon l'une des revendications 1 à 3, caractérisé en ce que les lames sont fixées sur le support et les pièces du montage et éventuellement entre elles par des couches métalliques adhérentes obtenues par cuisson de laque de métaux précieux.

5. Procédé selon l'une des revendications 1 à 4, caractérisé en ce que l'une (ou les) pièce(s) de guidage latéral du dispositif est (ou sont) remplacée(s) après le positionnement précis des lames et avant la croissance, par un collage latéral avec une couche métallique épaisse obtenue par cuisson à haute température de laque de métaux précieux.

6. Procédé selon la revendication 3 ou 4, caractérisé en ce que lesdits métaux précieux sont l'argent, l'or, le platine.

7. Procédé selon l'une des revendications 1 à 6, caractérisé en ce que le support et les pièces de guidage latéral sont constitués de matériaux ayant des coefficients de dilatation similaires à ceux des matériaux à assembler.

8. Procédé selon l'une des revendications 1 à 7, caractérisé en ce que les cristaux sont des cristaux de quartz ou du phosphate ou arséniate métallique isomorphe du quartz, tels que le phosphate d'aluminium A1PO4 ou le phosphate de gallium GaPO4.

9. Procédé selon l'une des revendications précédentes, caractérisé en ce que l'on accroît la taille des cristaux de berlinite selon la direction y.

10. Procédé d'accroissement des dimensions de cristaux de quartz selon l'une des revendications 1 à 9, caractérisé en ce que le support et les pièces de guidage sont constitués d'un acier à très faible dilatation du type Invar®, Elinvar®, Durinval®, de préférence revêtu d'une couche d'argent.

11. Procédé d'accroissement des dimensions de cristaux de phosphate ou arséniate métalliques selon l'une des revendications 1 à 9, caractérisé en ce que le support et les pièces de guidage latéral sont constitués de silice vitreuse pure ou de quartz cristallin.

12. Procédé selon l'une des revendications précédentes, caractérisé en ce que l'on effectue :

(1) une croissance du germe obtenu par les lames assemblées puis une découpe de nouvelles lames dans le monocristal obtenu, et
(2) une nouvelle croissance d'un germe obtenu par assemblage desdites nouvelles lames,

de manière à obtenir une augmentation progressive de la surtension des cristaux obtenus par modification des paramètres de croissance.

13. Cristaux de berlinite pouvant être obtenus par le procédé selon l'une des revendications 1 à 12, caractérisés en ce qu'ils ont une grande taille, notamment supérieure à 10 cm, et une haute pureté avec une teneur en impureté OH inférieure à 30ppm et un facteur de surtension Q supérieur à 750 000 à 5 MHz.

14. Cristaux de berlinite selon la revendication 13, caractérisés en ce qu'ils ont une morphologie isomérique selon les axes de croissance x et z.

**Claims**

1. Process for increasing the dimensions of quartz crystals and of quartz-isomorphic materials, which can be produced by hydrothermal growth from seed, in which a seed obtained by assembly of several crystalline plates is used, characterized in that there are assembled at least two plates of strictly identical lengths and/or widths and of similar thicknesses, cut from at least one crystal and exhibiting, on at least three faces, crystalline orientations, the deviations from which, between the plates, remain smaller than about 10" of arc, and in that the said plates are brought together on a support by guidance elements, thus ensuring their alignment on the aforementioned three faces while maintaining crystalline orientation deviations smaller than about 10" of arc, one face per plate being left free for growth of the assembled seeds, leading to the production of a single crystal having at least one dimension greater than that corresponding to the original crystalline plates, and the said plates being assembled using a device consisting of:

   - a planar support against which one of the said three faces is applied, and
   - two lateral guidance parts with a plane surface acting jointly with the two other faces of the said three faces by clamping, the said support and the said lateral guidance parts thus ensuring that the said plates are held in position.

2. Process according to Claim 1, characterized in that the said crystalline plates have forms inscribed in a parallelepiped so that they consist of six main faces which are parallel in pairs and perpendicular to each of the three main directions corresponding to the width, the length and the thickness of the parallelepiped

   - four faces of which, perpendicular in pairs on one hand, to the thickness and on the other hand, to the width or to the length, exhibiting orientation deviations between them, in pairs in the same plate on one hand, and from one plate to the other on the other hand, smaller than about 10" of arc, and
   - the two other faces, respectively perpendicular to the length or to the width, exhibiting deviations beween them in respect of the same plate and from one plate to the other ranging up to about 5' of arc,
   - the two faces perpendicular to the length or to the width being guided and held by the said lateral guidance and holding parts,
   - one of the faces perpendicular to the thickness being applied against the said planar support and the other face perpendicular to the thickness being left entirely free for growth,
   - the said plates being assembled by their faces perpendicular to the length or to the width.

3. Process according to either of Claims 1 and 2, characterized in that all the faces of the assembled plates, except those meant for growth, are coated with thin metallic layers, in particular of precious metals, preventing dissolution and growth.

4. Process according to one of Claims 1 to 3, characterized in that the plates are secured to the support and to the device parts and if appropriate to each other by adherent metallic layers obtained by the baking of a lacquer of precious metals.

5. Process according to one of Claims 1 to 4, characterized in that one (or the) lateral guidance part(s) of the device is (or are) replaced after precise positioning of the plates and before growth, by lateral cementing with a thick metallic layer obtained by high temperature baking of a lacquer of precious metals.

6. Process according to Claim 3 or 4, characterized in that the said precious metals are silver, gold or platinum.

7. Process according to one of Claims 1 to 6, characterized in that the support and lateral guidance parts consist of materials having expansion coefficients similar to those of the materials to be assembled.

8. Process according to one of Claims 1 to 7, characterized in that the crystals are crystals of quartz or of quartz-isomorphic metal phosphate or metal arsenate, such as aluminium phosphate $A1PO_4$ or gallium phosphate $GaPO_4$.

9. Process according to one of the preceding claims, characterized in that the size of berlinite crystals is increased along the y direction.

10. Process for increasing the dimensions of quartz crystals according to one of Claims 1 to 9, characterized in that the support and the guidance parts are made of a very low expansion steel of the Invar®, Elinvar®, Durinval® type, preferably coated with a silver layer.

11. Process for increasing the dimensions of metal phosphate or metal arsenate crystals according to one of Claims 1 to 9, characterized in that the support and lateral guidance parts are made of pure vitreous silica or of crystalline quartz.

12. Process according to one of the preceding claims, characterized in that the following are carried out:

(1) growth of the seed obtained by the assembled plates, then cutting of new plates from the single crystal obtained, and
(2) new growth of a seed obtained by assembly of the said new plates,

in order to obtain a progressive increase in the Q-factor of the crystals obtained by modification of the growth parameters.

13. Crystals of berlinite which can be obtained by the process according to one of Claims 1 to 12, characterized in that they are of large size, in particular larger than 10 cm, and of high purity with an OH impurity content of less than 30 ppm and a Q-factor of greater than 750,000 at 5 MHz.

14. Crystals of berlinite according to Claim 13, characterized in that they have an isometric morphology along the x and z growth axes.

**Patentansprüche**

1. Verfahren zur Vergrößerung der Dimensionen von Quarzkristallen und von zu Quarz isomorphen Materialien, die durch hydrothermales Wachstum auf einem Keim erzeugt werden, bei dem ein Keim verwendet wird, der durch Zusammenfügen von mehreren kristallinen Plättchen erhalten worden ist, dadurch gekennzeichnet, daß wenigstens zwei Plättchen von exakt identischer Länge und/oder Breite und ähnlicher Dicke zusammengefügt werden, die zu wenigsten einem Kristall geschliffen werden, und der auf drei Flächen wenigstens kristalline Orientierungen zeigt, deren Abweichungen zwischen den Plättchen unter etwa 10 Bogensekunden bleiben, und dadurch daß die Plättchen auf einem Träger durch Führungselemente einander angenähert werden, die dann ihre Ausrichtung auf die drei vorgenannten Flächen gewährleisten, indem die Abweichungen der kristallinen Orientierung unter etwa 10 Bogensekunden gehalten werden, wobei eine Fläche pro Plättchen frei belassen wird, im Hinblick auf das Wachstum der zusammengefügten Keime, das zur Erzeugung eines Einkristalls führt, der wenigstens eine Dimension aufweist, die größer ist als diejenige, die den kristallinen Ausgangsplättchen entspricht, wobei die Plättchen mit Hilfe eines Aufbaus zusammengefügt werden, der folgendes umfaßt:

- einen Flächenhalter, gegen den eine der drei Flächen gelehnt ist, und
- zwei Elemente zur seitlichen Führung mit glatter Oberfläche, die jeweils in die beiden anderen Flächen der drei Flächen durch Andrücken eingreifen, wobei der Halter und die Elemente zur seitlichen Führung dann das In-Position-Halten der Plättchen gewährleisten.

2. Verfahren nach Anspruch 1, dadurch gekennzeichnet, daß die Kristallplättchen Formen aufweisen, die so in einen Parallelflach einbeschrieben sind, daß sie sechs Hauptflächen umfassen, die zu je zweien parallel zueinander und senkrecht zu jeder der drei Hauptrichtungen sind, die der Breite, Länge und Dicke des Parallelflaches entsprechen,

- wovon vier Flächen, die zu je zweien einerseits zur Dicke und andererseits zur Breite oder Länge senkrecht sind, untereinander Abweichungen in der Orientierung zu je zweien in einem gleichen Plättchen einerseits und von einem Plättchen zum anderen andererseits aufweisen, die kleiner sind als etwa 10 Bogensekunden, und wobei
- die zwei anderen Flächen, die jeweils senkrecht zur Länge oder Breite sind, Abweichungen untereinander für ein gleiches Plättchen und von einem Plättchen zum anderen aufweisen, die bis zu ungefähr 5 Bogenminuten reichen können,
- die beiden zur Länge oder Breite senkrechten Flächen durch die Elemente zur Führung und zum seitlichen Halt geführt und gehalten werden,
- eine der zur Dicke senkrechten Flächen auf den Flächenhalter aufgelegt und die andere zur Dicke senkrechte Fläche für das Wachstum völlig frei belassen wird,
- die Plättchen mit ihre Flächen, die zur Länge oder Breite senkrecht sind, zusammengefügt werden.

3. Verfahren nach einem der Ansprüche 1 oder 2, dadurch gekennzeichnet, daß sämtliche Flächen der zusammengefügten Plättchen, außer denjenigen, die zum Wachstum bestimmt sind, mit dünnen Metallbeschichtungen, insbesondere aus Edelmetallen, beschichtet werden, die eine Auflösung und ein Wachstum verhindern.

4. Verfahren nach einem der Ansprüche 1 bis 3, dadurch gekennzeichnet, daß die Plättchen auf dem Träger und auf den Elementen des Aufbaus fixiert werden und gegebenenfalls untereinander durch die metallischen Haftbeschichtungen fixiert werden, die durch Brennen zu Lack aus Edelmetallen erhalten werden.

5. Verfahren nach einem der Ansprüche 1 bis 4, dadurch gekennzeichnet, daß ein (oder die) Element (e) zur seitlichen Führung der Vorrichtung nach der genauen Positionierung der Plättchen und vor dem Wachstum durch eine seitliche Verklebung mit einer dicken Metallbeschichtung, die durch Brennen bei hoher Temperatur zu Lack aus Edelmetallen erhalten worden ist, ausgewechselt wird (werden).

6. Verfahren nach Anspruch 3 oder 4, dadurch gekennzeichnet, daß die Edelmetalle Silber, Gold, Platin sind.

7. Verfahren nach einem der Ansprüche 1 bis 6, dadurch gekennzeichnet, daß der Träger und die Elemente zur seitlichen Führung aus Materialien bestehen, die Ausdehnungskoeffizienten aufweisen, die denjenigen der zusammenzufügenden Materialien entsprechen.

8. Verfahren nach einem der Ansprüche 1 bis 7, dadurch gekennzeichnet, daß die Kristalle Quarz- oder Metallphosphat- oder Metallarsenatkristalle sind, die zu Quarz isomorph sind, wie Aluminiumphosphat $AlPO_4$ oder Galliumphosphat $GaPO_4$.

9. Verfahren nach einem der vorhergehenden Ansprüche, dadurch gekennzeichnet, daß man die Größe der Berlinitkristalle in Y-Richtung wachsen läßt.

10. Verfahren zur Vergrößerung der Dimensionen von Quarzkristallen nach einem der Ansprüche 1 bis 9, dadurch gekennzeichnet, daß der Träger und die Elemente zur Führung aus einem Stahl mit sehr geringer Ausdehnung vom Typ Invar®, Elinvar®, Durinval®, der vorzugsweise mit einer Silberschicht beschichtet ist, bestehen.

11. Verfahren zur Vergrößerung der Dimensionen von Metallphosphat- oder Metallarsenatkristallen nach einem der Ansprüche 1 bis 9, dadurch gekennzeichnet, daß der Träger und die Elemente zur seitlichen Führung aus reinem Quarzglas oder aus kristallinem Quarz bestehen.

12. Verfahren nach einem der vorhergehenden Ansprüche, dadurch gekennzeichnet, daß man folgende Schritte durchführt:

   (1) ein Wachstum des Keims, der erhalten wurde durch die zusammengefügten Plättchen und durch ein anschließendes Abschneiden von neuen Plättchen an dem erhaltenen Einkristall, und
   (2) ein neues Wachstum eines Keims, der durch Zusammenfügen der neuen Plättchen erhalten wurde,

um einen schrittweisen Anstieg der Zugspannung der Kristalle zu erhalten, die durch Modifikation der Wachstumsparameter erhalten worden sind.

13. Berlinitkristalle, die durch das Verfahren nach einem der Ansprüche 1 bis 12 erhalten werden können, dadurch gekennzeichnet, daß sie langgewachsen sind, insbesondere über 10 cm, und eine hohe Reinheit mit einem Gehalt an OH-Verunreinigung unter 30 ppm und einem Gütefaktor Q von größer als 750 000 bis 5 MHz besitzen.

14. Berlinitkristalle nach Anspruch 13, dadurch gekennzeichnet, daß sie entlang der Wachstumsachsen x und z eine isomere Morphologie aufweisen.

FIG_1a : QUARTZ GERME Z

FIG_1b : BERLINITE GERME Z

FIG. 2 : BERLINITE GERME X

FIG. 3 : QUARTZ GERME Z $(10\overline{1}1)$

FIG. 4 : QUARTZ GERME r $(01\overline{1}1)$

Fig. 5a

Fig. 5b

FIG. 5

FIG. 6a

FIG. 6b

FIG_7

FIG_8

10

FIG. 9

FIG. 10

FIG_11a

FIG_11b

FIG_12

EP 0 515 288 B1